# EUROPÄISCHE PATENTSCHRIFT

(11) **EP 0 402 368 B1**
(45) Veröffentlichungstag und Bekanntmachung des Hinweises auf die Patenterteilung: **11.08.1993**
(21) Anmeldenummer: 89902255.2
(22) Anmeldetag: 10.02.1989
(51) Int. Cl.: C23C 16/04, C23C 16/48, C23C 16/46, H01L 21/31

(54) **CVD-VERFAHREN ZUM NIEDERSCHLAGEN EINER SCHICHT AUF EINER ELEKTRISCH LEITFÄHIGEN DÜNNSCHICHTSTRUKTUR**
CVD PROCESS FOR DEPOSITING A LAYER ON AN ELECTRICALLY CONDUCTIVE THIN-LAYER STRUCTURE
PROCEDE CVD DE DEPOT D'UNE COUCHE SUR UNE STRUCTURE ELECTROCONDUCTRICE A COUCHE MINCE

(30) Priorität: 16.02.1988 DE 3804805
(43) Veröffentlichungstag der Anmeldung: 19.12.1990
(73) Patentinhaber: Max-Planck-Gesellschaft zur Förderung der Wissenschaften e.V., D-37073 Göttingen (DE)
(72) Erfinder: GOTTSLEBEN, Oliver, D-3400 Göttingen (DE); STUKE, Michael, D-3400 Göttingen (DE)
(74) Vertreter: von Bezold, Dieter, Dr.
(86) Internationale Anmeldenummer: EP8900126
(87) Internationale Veröffentlichungsnummer: WO8907665

(56) Entgegenhaltungen:
- DE-A- 3 126 050
- DE-A- 3 703 498
- Applied Physics Letters, Volume 50, Nr. 15, 13 April 1987 (New York, US) J.G. Black et al.: "Supplemental multilevel interconnects by laser direct writing: application to GaAs digital integrated circuits" pages 1016-1018, see page 1016 last paragraph cited in the applica- tion
- Patent Abstracts of Japan, Volume 11, Nr.184, (C-427) (2631) 12 June 1987 & JP, A, 624871 (NEC CORP) 10 January 1987
- Patent Abstracts of Japan, Volume 11, Nr. 185 (C-428) (2632) 13 SJune 1987 & JP, A, 6210275 (CANON ING.) 19 January 1987

## Beschreibung

Die vorliegende Erfindung betrifft ein CVD-Verfahren zum Niederschlagen einer Schicht aus einem vorgegebenen Material auf einer elektrisch leitfähigen Dünnschichtstruktur, die auf einem Substrat angeordnet ist, mittels einer das vorgegebene Material liefernden, thermisch induzierten Reaktion einer dampfförmigen oder auf der Substratoberfläche adsorbierten oder als Film niedergeschlagenen Verbindung. Ferner betrifft die Erfindung eine Einrichtung zum Durchführen eines solchen Verfahrens.

Es ist bekannt, eine dünne Schicht aus einem vorgegebenen Material durch thermisch induziertes chemisches Niederschlagen aus der Gasphase, also mit Hilfe einer thermisch induzierten Reaktion einer dampfförmigen Verbindung zu erzeugen, die bei der Reaktion das betreffende Material liefert. Bei der chemischen Reaktion kann es sich um eine einfache thermische Zersetzung oder um eine Reduktion oder irgend eine andere geeignete Reaktion handeln. Dieses als "CVD" bekannt gewordene Verfahren hat in jüngerer Zeit auch Bedeutung für die direkte Herstellung von Dünnschicht-Metallmustern, wie elektrischen Leiterstrukturen, auf Substraten, wie Chips von integrierten Schaltungen und dergl. erlangt, wobei die Einleitung der chemischen Reaktion und damit die Definition des Metallmusters durch einen auf die Oberfläche des Substrats fokussierten Laserstrahl erfolgt. Bei einem bekannten "Direktschrift"-Laser-CVD-Verfahren (I. G. Black et al, Appl. Phys. Lett. 50 (15), 13. April 1987, S. 1016-1018) wird Wolfram durch Reduktion von Wolframhexafluorid mittels Wasserstoff niedergeschlagen, wobei metallisches Wolfram und Fluorwasserstoffsäure entstehen.

Es ist oft erwünscht, Dünnschicht-Metallstrukturen, die durch Direktschrift-Laser-CVD oder auf andere Weise hergestellt worden sind, zu verstärken, d.h. die (senkrecht zur Substratoberfläche gerechnete) Dicke der Metallstrukturen durch zusätzliches Material zu verstärken, wobei es sich bei diesem zusätzlichen Material um das gleiche Material wie das der primären Schichtstruktur oder auch um ein verschiedenes Material handeln kann. Eine entsprechende Aufgabenstellung kann auch bei nichtmetallischen, elektrisch leitfähigen Strukturen auftreten.

Die vorliegende Erfindung löst diese Aufgabe dadurch, daß die zu verstärkende elektrisch leitfähige Struktur (Leiterstruktur) in Gegenwart einer dampfförmigen chemischen Verbindung, die bei einer thermisch induzierten chemischen Reaktion das gewünschte zusätzlich niederzuschlagende Material liefert, durch elektrischen Stromdurchgang erhitzt wird.

Durch die selektive und praktisch ausschließliche Erhitzung der Leiterstruktur durch in ihr erzeugte Joule'sche Wärme entsteht ein sehr gut definierter Niederschlag des zusätzlichen Materials ausschließlich auf der erhitzten Struktur.

Die Erhitzung erfolgt vorzugsweise dadurch, daß mit Hilfe von an die Leiterstruktur angelegten Elektroden ein Strom einer für die Erhitzung ausreichenden Stärke durch die zu verstärkende elektrisch leitfähige Struktur geleitet wird. Die Erhitzung kann jedoch auch auf induktivem Wege, z. B. durch Induzieren eines hochfrequenten Stromes, erfolgen.

Der Stromdurchgang erfolgt vorzugsweise impulsförmig, so daß sich die zu verstärkende Leiterstruktur schnell erhitzt und wenig Zeit für einen Wärmeübergang auf das Substrat verbleibt. Entsprechendes gilt auch für die induktive Heizung.

Die Gasatmosphäre, die während der Stromerhitzung mit der Metall- oder Leiterstruktur in Berührung ist, enthält vorzugsweise ein Gemisch aus WF₆ und H₂, es können jedoch auch andere Gasatmosphären verwendet werden, z. B. WCl₆/H₂, W(CO)₆, W(PF₃)₆ u. a. m. (hinsichtlich der Abscheidung von Wolfram durch CVD siehe z. B. C.-E. Morosanu et al., Thin Solid Films, 52 (1978) 181-194).

Im folgenden wird die Erfindung am Beispiel der bevorzugten Anwendung zur Verstärkung einer elektrisch leitfähigen Strukur aus Metall unter Bezugnanme auf die Zeichnungen näher erläutert.

Es zeigen:
- Fig. 1: eine vereinfachte Darstellung eines Teiles einer Apparatur zur Herstellung von Metallmustern durch Laser-CVD;
- Fig. 2: eine schematische Darstellung der Apparatur gemäß Fig. 1 mit einer Zusatzvorrichtung zum Verstärken der durch Laser-CVD gebildeten Metallstrukturen;
- Fig. 3: stark vergrößerte Profilquerschnitte eines linienförmigen elektrischen Leiters.

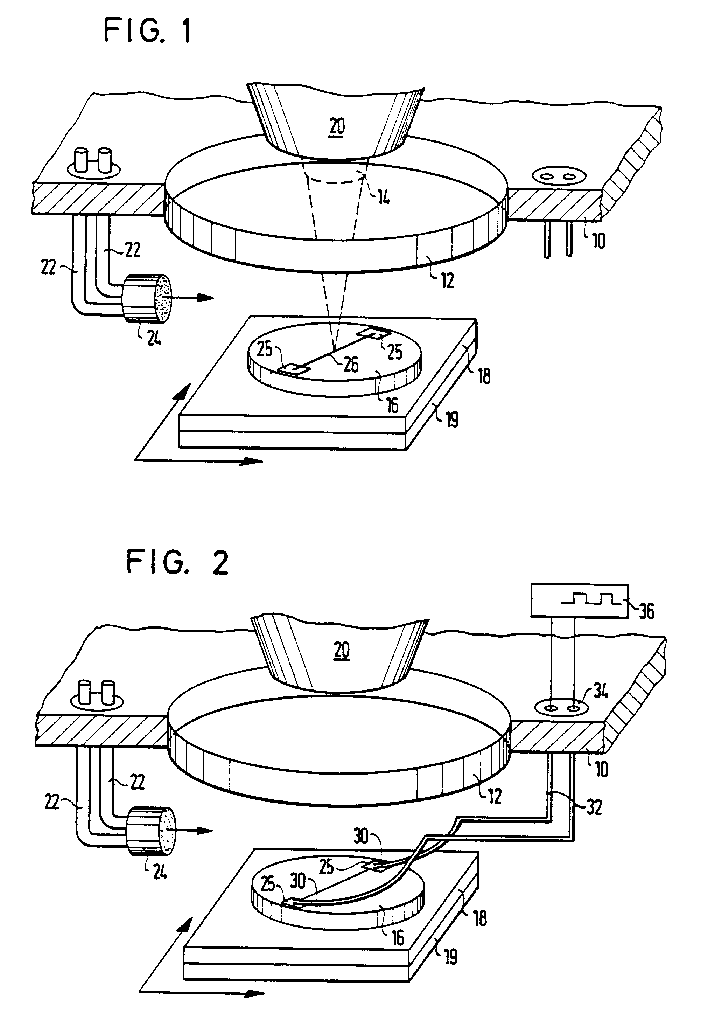

Die Figuren 1 und 2 zeigen schematisch die für die vorliegende Erfindung wesentlichen Teile einer Apparatur zur Durchführung einer bevorzugten Ausführungsform des vorliegenden Verfahrens.

Die in Fig. 1 und 2 dargestellte Apparatur hat ein gasdichtes Metallgehäuse (10) mit einem optischen Fenster (12), durch das ein Laserstrahlungsbündel (14) auf die Oberfläche eines Substrats (16) fokussiert wird, welches auf einer Substrathalterung (18) angeordnet ist. Bei dem dargestellten Ausführungsbeispiel hat die Laserstrahlung eine Wellenlänge von 514,5 nm - und wird durch einen Argonionenlaser (20) erzeugt. Das Gehäuse (10) weist ferner eine Durchführung für zwei Gasleitungen (22) auf, die von einem sich außerhalb des Gehäuses befindenden, nicht dargestellten Gaszuführungssystem zu einem im Gehäuse (10) angeordneten Mischkopf (24) führen. Bei dem beschriebenen Ausführungsbeispiel wird durch die eine Leitung Wolframhexafluorid und durch die andere Leitung Wasserstoff mit dem molaren Verhältnis WF₆ /H₂ von 1:10 so zugeführt, daß im Gehäuse Partialdrücke von 3 kPa (30 mbar) WF₆ und 30 kPa (300 mbar) H₂ herrschen. Das Substrat (16) besteht hier aus einem Keramikplättchen aus 96% reinem Al₂O₃, dessen Oberfläche bis zu einer maximalen Rauheit von etwa 250 nm poliert ist. Die Oberfläche wurde mit Ethanol gereinigt. Auf zwei Bereiche, die etwa 5 bis 6 mm voneinander entfernt sind, wurden Anschlußflecke durch Aufsputtern von Gold gebildet.

Die Substrathalterung (18) ist ein computergesteuerter Mikroskoptisch mit einem Positionsauf lösungsvermögen von 0,25 µm und weist eine nur schematisch dargestellte Temperiervorrichtung (19), insbesondere Kühlvorrichtung auf, mit der ein Film einer metallorganischen oder anderen geeigneten Verbindung auf der Substratoberfläche zur Absorption, zur Kondensation oder zum Ausfrieren gebracht werden kann. Die Laserstrahlung (14) wird durch ein Mikroskopobjektiv mit einem Arbeitsabstand von 8 mm fokussiert und die an der Substratoberfläche verfügbare Laserstrahlungsleistung beträgt etwa 1,5 Watt. Die Substrathalterung (18) kann auch mit einer Heizvorrichtung versehen sein.

Mit der beschriebenen Apparatur wurde auf der Oberfläche des Keramiksubstrats (16) mittels des fokussierten Laserstrahlungsbündels ein streifenförmiger Leiter (26) aus Wolfram mit einer Schreibgeschwindigkeit von 250 um/s zwischen den Anschlußflecken gebildet. Der spezifische Widerstand des durch Laser-CVD gebildeten Wolframs des Leiters (26) betrug etwa 13 bis 20 µOhm·cm ist also höher als der spezifische Widerstand 5,6 µOhm·cm von massivem Wolfram. Die durch das Auflösungsvermögen der Mikroskopoptik begrenzte Messung der Breite des durch Laser-CVD niedergeschlagenen Wolframleiters ergab etwa 5 bis 6 µm (Halbwertsbreite).

Zur Verstärkung des durch Laser-CVD niedergeschlagenen linienförmigen Leiters (26) wird dieser in Gegenwart der erwähnten WF₆/H₂-Reaktionsmischung durch direkten elektrischen Stromdurchgang erhitzt, so daß auf dem primären Wolframniederschlag weiteres Wolfram abgeschieden wird. Hierzu werden die beiden Anschlußflecke mit Stromzuführungselektroden (30) kontaktiert, die über Anschlußleitungen (32) und eine Durchführung (34) mit einer Impulsstromquelle (36) verbunden sind. Die Impulsstromquelle (36) liefert kurze Stromimpulse hoher Amplitude. Die Dauer, Wiederholungsfrequenz und Amplitude der Impulse werden so gewählt, daß keine Beschädigung der zu erhitzenden Leiterstruktur oder des Substrats auftreten. Eine bevorzugte Impulsstromquelle (36) liefert elektrische Impulse mit einer einstellbaren Spannung bis zu ca. 30 V, einer einstellbaren Dauer zwischen etwa 10 bis 100 ms und einer einstellbaren Wiederholungsfrequenz von etwa 2 bis 30 Hz. Die Dauer der Impulsstromzuführung kann einige Minuten bis über 20 min betragen. Man kann den Strom bzw. die Spannung auch von Hand schalten.

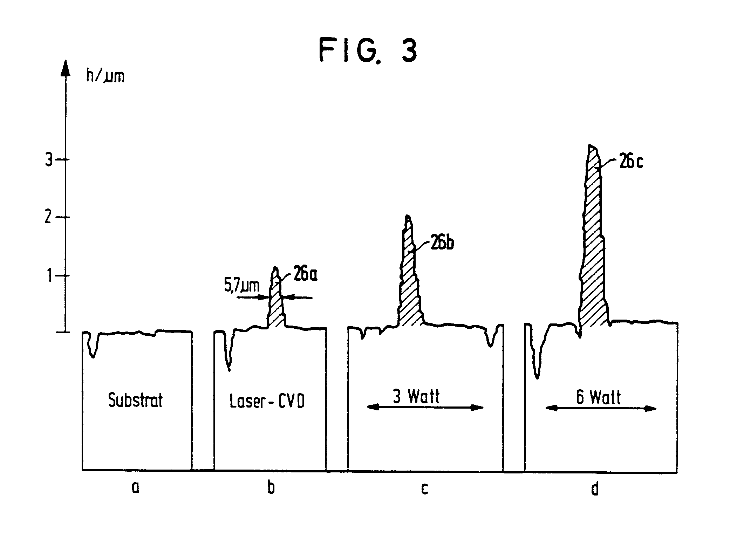

Fig. 3 zeigt bei a ein Querschnittsprofil des unbeschichteten Substrats, bei b ein Querschnittsprofil eines durch Laser-CVD gebildeten Leiters (26a); bei c ein Querschnittsprofil (26b) eines durch Laser-CVD gebildeten Leiters (entsprechend 26a) nachdem dieser 5 Minuten durch Stromdurchgang mit einer mittleren Leistung von 3 Watt verstärkt worden ist und d zeigt ein Querschnittsprofil eines durch Laser-CVD gebildeten Leiters, nachdem er durch Stromdurchgang von 5 Minuten bei 6 Watt mittlerer Leistung verstärkt worden ist. Hierbei wurde von Hand eine Spannung von ca. 15 V (3 W) bzw. ca. 25 V (6 W) fünf Minuten lang abwechselnd für jeweils 10 s eingeschaltet und für 5 s abgeschaltet.

Die Haftung der in der beschriebenen Weise verstärkten Leiterstruktur ist ausgezeichnet. Neben den durch Stromdurchgang erhitzten Leiterstrukturen wurde kein niedergeschlagenes Wolfram gefunden.

Selbstverständlich sind die Parameter des oben beschriebenen Ausführungs-beispiels nicht einschränkend auszulegen, sonderen können je nach Bedarf und Versuchsbedingungen abgeändert werden. Das Verstärkungsmaterial braucht nicht das gleiche zu sein wie das ursprünglich abgeschiedene Metall, es kann ein anderes Metall oder eine Legierung und gewünschtenfalls auch ein Halbleiter oder ein Isoliermaterial oder auch ein keramischer Hochtemperatur-Supraleiter sein. Auch mehrschichtige Strukturen können in der beschriebenen Weise gebildet werden indem man bei den verschiedenen Erhitzungsschritten verschiedene Dampfatmosphären verwendet. Anstatt durch galvanischen Stromdurchgang kann die Erhitzung auch durch induktive Erhitzung, also Wirbelstromheizung, z. B. mit Hochfrequenz, erfolgen, wenn das zu verstärkende Metallmuster und das Substrat dies zulassen. Die durch das vorliegende Verfahren zu verstärkende Struktur kann auch aus einem nichtmetallischen Material, wie Kohlenstoff (Graphit), einem Halbleitermaterial oder einer elektrisch leitfähigen Verbindung bestehen.

Besonders vorteilhaft hat sich auch die Verstärkung von Leiterstrukturen aus Wolfram mit Gold erwiesen, wobei die Atmosphäre während der durch Stromdurchgang bewirkten Erhitzung der Leiterstruktur eine kommerziell erhältliche organometallische Goldverbindung (Firma Doduco KG) enthielt.

## Patentansprüche

**1.** CVD-Verfahren zum Niederschlagen einer Schicht aus einem vorgegebenen Material auf einer elektrisch leitfähigen Schichtstruktur, die auf einem Substrat angeordnet ist, mittels einer das vorgegebene Material liefernden, thermisch induzierten Reaktion einer dampfförmigen oder auf der Substratoberfläche adsorbierten oder als Film niedergeschlagenen Verbindung, **dadurch gekennzeichnet**, daß die Schichtstruktur durch einen in ihr erzeugten elektrischen Strom erhitzt wird.

**2.** Verfahren nach Anspruch 1, **dadurch gekennzeichnet**, daß die Dünnschichtstruktur aus Metall besteht.

**3.** Verfahren nach Anspruch 1 oder 2, **dadurch gekennzeichnet**, daß die Schichtstruktur durch ein Direktschrift-Laser- CVD-Verfahren auf dem Substrat gebildet wird.

**4.** Verfahren nach Anspruch 1 oder 2, **dadurch gekennzeichnet**, daß die Reaktion einen metallischen Niederschlag liefert.

**5.** Verfahren nach Anspruch 1 oder 2, **dadurch gekennzeichnet**, daß die Reaktion das Material, aus dem die Schichtstruktur besteht, liefert.

**6.** Verfahren nach Anspruch 1 oder 2, **dadurch gekennzeichnet**, daß die Reaktion ein halbleitendes Material liefert.

**7.** Verfahren nach Anspruch 1 oder 2, **dadurch gekennzeichnet**, daß die Reaktion ein dielektrisches Material liefert.

**8.** Verfahren nach Anspruch 1 oder 2, **dadurch gekennzeichnet**, daß es mindestens zweimal unter Verwendung unterschiedlicher Verbindungen durchgeführt wird.

**9.** Verfahren nach Anspruch 1 oder 2, **dadurch gekennzeichnet**, daß als dampfförmige Verbindung ein flüchtiges Wolframhalogenid, wie WF₆ oder WCl₆, in Mischung mit Wasserstoff verwendet wird.

**10.** Verfahren nach Anspruch 9, **dadurch gekennzeichnet**, daß das Verhältnis von Wolframhalogenid zu Wasserstoff etwa 1:10 beträgt.

**11.** Verfahren nach einem der vorhergehenden Ansprüche, **dadurch gekennzeichnet**, daß die Schichtstruktur aus Wolfram hergestellt wird.

**11.** Verfahren nach einem der vorhergehenden Ansprüche, **dadurch gekennzeichnet**, daß die Schichtstruktur durch galvanisches Hindurchleiten des elektrischen Stromes erhitzt wird.

**13.** Verfahren nach Anspruch 11, **dadurch gekennzeichnet**, daß ein impulsförmiger Strom verwendet wird.

**14.** Verfahren nach einem der Ansprüche 1 bis 10, **dadurch gekennzeichnet**, daß der Strom durch Induktion in der Dünnschichtstruktur erzeugt wird.

**15.** Einrichtung zum Niederschlagen einer Schicht aus einem vorgegebenen Material auf einer elektrisch leitfähigen Schichtstruktur, Durchführen des Verfahrens nach Anspruch 1, mit einer Kammer (10), einer Vorrichtung (22, 24) zum Einleiten einer dampfförmigen Verbindung, die bei einer thermisch induzierten chemischen Reaktion eine Schicht des vorgegebenen Materials liefert, und einer Halterung (18) für ein Substrat (16), auf dessen Oberfläche sich die Schichtstruktur (26) befindet, gekennzeichnet durch zwei Elektroden (30) zum Kontaktieren der Dünnschichtstruktur und eine mit den Elektroden verbundene Stromquelle (36), die einen Strom mit einer für die Erhitzung der Dünnschichtstruktur ausreichenden Stärke zu liefern vermag.

**16.** Einrichtung nach Anspruch 15, **dadurch gekennzeichnet**, daß die Substrathalterung (18) ein Positionierungstisch ist.

**17.** Einrichtung nach Anspruch 15 oder 16, **dadurch gekennzeichnet**, daß die Kammer (10) ein optisches Fenster (12) aufweist, durch das ein Laserstrahlungsbündel (14) auf die Oberfläche des Substrats (16) fokussierbar ist.

**18.** Einrichtung nach Anspruch 15, oder 16 oder 17 **gekennzeichnet durch** eine Vorrichtung zum Temperieren des Substrats.

## Claims

1. CVD process for depositing a layer of a predetermined material on an electrically conductive layer structure which is disposed on a substrate, by means of a thermally-induced reaction, providing the predetermined material, of a compound which is vaporous or adsorbed on the substrate surface, or deposited as a film, characterised in that the layer structure is heated by an electrical current produced therein.

2. Process according to claim 1, characterised in that the thin layer structure consists of metal.

3. Process according to claim 1 or 2, characterised in that the layer structure is formed on the substrate by a direct-writing laser CVD process.

4. Process according to claim 1 or 2, characterised in that the reaction produces a metallic deposit.

5. Process according to claim 1 or 2, characterised in that the reaction produces the material of which the layer structure is made.

6. Process according to claim 1 or 2, characterised in that the reaction produces a semiconductive material.

7. Process according to claim 1 or 2, characterised in that the reaction produces a dielectric material.

8. Process according to claim 1 or 2, characterised in that it is carried out at least twice, using different compounds.

9. Process according to claim 1 or 2, characterised in that a volatile tungsten halogenide such as WF₆ or WCl₆ admixed with hydrogen is used as a vaporous compound.

10. Process according to claim 9, characterised in that the ratio of tungsten halogenide to hydrogen is approximately 1:10.

11. Process according to one of the foregoing claims, characterised in that the layer structure is produced from tungsten.

12. Process according to one of the foregoing claims, characterised in that the layer structure is heated by galvanic passage of an electrical current therethrough.

13. Process according to claim 11, characterised in that a pulsed current is used.

14. Process according to one of claims 1 to 10, characterised in that the current is produced by induction in the thin layer structure.

15. Device for depositing a layer of a predetermined material upon an electrically conductive layer structure, in execution of the process according to claim 1, with a chamber (10), a device (22, 24) for introduction of a vaporous compound which, during a thermally-induced chemical reaction, produces a layer of the predetermined material, and with a holder (18) for a substrate (16) upon whose surface the layer structure (26) is located, characterised by two electrodes (30) for contacting the thin layer structure, and a current source (36), connected to the electrodes, and which is capable of delivering a current of sufficient intensity for heating the thin layer structure.

16. Device according to claim 15, characterised in that the substrate holder (18) is a positioning table.

17. Device according to claim 15 or 16, characterised in that the chamber (10) has an optical window (12), through which a laser beam (14) may be focused on the surface of the substrate (16).

18. Device according to claim 15, or 16 or 17, characterised by a device for tempering the substrate.

## Revendications

1. Procédé de dépôt de vapeur chimique ou CVD pour le dépôt d'une couche d'un matériau prédéterminé sur une structure de couche conductrice de l'électricité qui est placée sur un substrat, au moyen d'une réaction induite thermiquement, produisant le matériau prédéterminé, d'un composé sous forme de vapeur ou bien adsorbé sur la surface du substrat ou bien déposé en tant que pellicule, caractérisé en ce qu'on chauffe la structure de la couche au moyen d'un courant électrique produit dans cette structure.

2. Procédé suivant la revendication 1 caractérisé en ce que la structure de la couche mince est constituée d'un métal.

3. Procédé suivant l'une quelconque des revendications 1 ou 2 caractérisé en ce que la structure de la couche mince est formée sur le substrat par un procédé laser-CVD à inscription directe.

4. Procédé suivant l'une quelconque des revendications 1 ou 2 caractérisé en ce que la réaction produit un dépôt métallique.

5. Procédé suivant l'une quelconque des revendications 1 ou 2 caractérisé en ce que la réaction produit le matériau dont est constituée la structure de la couche.

6. Procédé suivant l'une quelconque des revendications 1 ou 2 caractérisé en ce que la réaction produit un matériau semi-conducteur.

7. Procédé suivant l'une quelconque des revendications 1 ou 2 caractérisé en ce que la réaction produit un matériau diélectrique.

8. Procédé suivant l'une quelconque des revendications 1 ou 2 caractérisé en ce qu'il est exécuté au moins deux fois en utilisant des composés différents.

9. Procédé suivant l'une quelconque des revendications 1 ou 2 caractérisé en ce qu'on utilise, en tant que composé sous forme de vapeur, un halogénure de tungstène volatil, tel que WF₆ ou bien WCl₆, en mélange avec de l'hydrogène.

10. Procédé suivant la revendication 9 caractérisé en ce que le rapport entre l'halogénure de tungstène et l'hydrogène est d'environ 1 : 10.

11. Procédé suivant l'une quelconque des revendications précédentes caractérisé en ce que la structure de la couche est réalisée en tungstène.

12. Procédé suivant l'une quelconque des revendications précédentes caractérisé en ce que la structure de la couche est chauffée par le passage galvanique du courant électrique.

13. Procédé suivant la revendication 11 caractérisé en ce qu'on utilise un courant électrique impulsionnel.

14. Procédé suivant l'une quelconque des revendications 1 à 10 caractérisé en ce qu'on produit le courant, dans la structure de la couche mince, par induction.

15. Dispositif pour le dépôt d'une couche d'un matériau prédéterminé sur une structure de couche conductrice de l'électricité, par la mise en oeuvre du procédé suivant la revendication 1, comportant une enceinte (10), un dispositif (22,24) pour introduire dans cette enceinte un composé sous forme de vapeur qui produit, par suite d'une réaction chimique induite thermiquement, une couche du matériau prédéterminé, et un support (18) pour un substrat (16) sur la surface duquel se trouve la structure de la couche (26), caractérisé en ce qu'il comprend deux électrodes (30) destinées à venir en contact avec la structure de la couche mince et une source de courant (36) qui est reliée aux électrodes et qui peut produire un courant d'une intensité suffisante pour assurer le chauffage de la structure de la couche mince.

16. Dispositif suivant la revendication 15 caractérisé en ce que le support (18) du substrat est une table de mise en position.

17. Dispositif suivant l'une quelconque des revendications 15 ou 16 caractérisé en ce que l'enceinte (10) comporte une fenêtre optique (12) à travers laquelle un faisceau de rayonnement laser (14) peut être focalisé sur la surface du substrat (16).

18. Dispositif suivant l'une quelconque des revendications 15,16 ou 17 caractérisé en ce qu'il comporte un dispositif pour régler la température du substrat.
